# EUROPÄISCHE PATENTSCHRIFT

(11) **EP 0 963 141 B1**
(45) Veröffentlichungstag und Bekanntmachung des Hinweises auf die Patenterteilung: **16.06.2010**
(21) Anmeldenummer: 99105216.8
(22) Anmeldetag: 13.03.1999
(51) Int. Cl.: H05H 1/46, H01J 37/32

(54) **Vorrichtung zur Erzeugung von Plasma**
Device for plasma generation
Dispositif pour la génération de plasma

(30) Priorität: 05.06.1998 DE 19825125
(43) Veröffentlichungstag der Anmeldung: 08.12.1999
(73) Patentinhaber: Oerlikon Deutschland Holding GmbH, 50968 Köln (DE)
(72) Erfinder: Liehr, Michael, Dr., 36325 Feldatal (DE)

(56) Entgegenhaltungen:
- DE-A- 4 136 297
- DE-A- 19 503 205
- US-A- 4 265 730
- US-A- 4 566 403
- PATENT ABSTRACTS OF JAPAN Bd. 013, Nr. 470 (E-835), 24. Oktober 1989 (1989-10-24) & JP 01 184921 A (CANON INC), 24. Juli 1989 (1989-07-24)

## Beschreibung

Die Erfindung betrifft eine Vorrichtung zur Erzeugung von Plasma in einer Vakuumkammer mit Hilfe von elektromagnetischen Wechselfeldern, bei der ein stabförmiger Leiter innerhalb eines Rohres aus isolierendem Werkstoff in die Vakuumkammer hineingeführt ist, wobei der Innendurchmesser des Isolierrohres größer als der Durchmesser des Leiters ist und das Isolierrohr an einem Ende in der Wand der Vakuumkammer gehalten und gegenüber dieser an seiner Außenfläche abgedichtet ist und der Leiter an eine Quelle zur Erzeugung des elektromagnetischen Wechselfeldes angeschlossen ist.

Eine bekannte Vorrichtung zur Erzeugung von Plasma (DE 195 03 205) ermöglicht es, in einem begrenzten Betriebsbereich (Prozeßbereich, Gasdruck, Mikrowellenleistung) Plasmen für Oberflächenbehandlungen und Beschichtungstechnik zu erzeugen. Die bekannte Vorrichtung besteht im wesentlichen aus einem in einer Vakuumprozeßkammer installierten zylindrischen Glasrohr und einem darin befindlichen metallisch leitenden Rohr, wobei im Innenraum des Glasrohrs Atmosphärendruck herrscht. Mikrowellenleistung wird beidseitig durch zwei Einspeisungen und zwei metallische Koaxialleitungen, bestehend aus Innenleiter und Außenleiter, durch die Wände der Vakuumprozeßkammer eingeleitet. Der fehlende Außenleiter der Koaxialleitung innerhalb der Vakuumprozeßkammer wird durch eine Plasmaentladung ersetzt, die bei hinreichenden Zündbedingungen (Gasdruck) durch die Mikrowellenleistung gezündet und aufrechterhalten wird, wobei die Mikrowellenleistung aus den beiden metallischen Koaxialleitungen und durch das Glasrohr in die Vakuumprozeßkammer austreten kann. Das Plasma umschließt das zylinderförmige Glasrohr von außen und bildet zusammen mit dem Innenleiter eine Koaxialleitung mit sehr hohem Dämpfungsbelag. Bei feststehender, beidseitig eingespeister Mikrowellenleistung kann der Gasdruck der Vakuumprozeßkammer so eingestellt werden, daß das Plasma augenscheinlich gleichmäßig entlang der Vorrichtung dort brennt, wo innerhalb der Vakuumprozeßkammer der Außenleiter der Koaxialleitung fehlt.

Wenn der Gasdruck in der Vakuumprozeßkammer bei voreingestellter Mikrowellenleistung erhöht wird, geht jedoch erfahrungsgemäß die Gleichmäßigkeit des Plasmas entlang der Vorrichtung verloren. Das Plasma in etwa halber Distanz zwischen Einspeisungspunkten der Vorrichtung wird optisch schwächer und kann ab einem gewissen Druck gänzlich erlöschen. Die Plasmalinie "reißt auf" und die beiden entstehenden Teilplasmen ziehen sich bei weiterer Druckerhöhung in Richtung der Einspeisungen zurück. Insbesondere bei langen Vorrichtungen (z. B. ab 1 m) führt dieser Effekt zu ungleichmäßigen Plasmen und daraus resultierenden ungleichmäßigen Vakuumprozessen. Die Teilplasmen zeigen hohe Leuchtkraft an den Einspeisungsenden in der Nähe der Wände und werden zur Mitte hin schwächer.

Die Dämpfung der Mikrowellen hängt in keiner Weise von der Position entlang der Koaxialleitung ab. Da die dielektrische Füllung der Koaxialleitung aus Luft besteht und die relative Dielektrizitätskonstante des Dielektrikums der Koaxialleitung über die Länge der Vorrichtung konstant ist, hängt die Höhe der Dämpfung nur von der Eindringtiefe der Mikrowellen in die leitenden Oberflächen ab. Bei konstanter Dämpfung pro Längeneinheit heißt das, daß die netto an das Plasma pro Längeneinheit abgegebene Mikrowellenleistung entlang der Vorrichtung zur Mitte hin absinkt. Da der Außenleiter aus Plasma besteht, kann diese Leitfähigkeit nicht exakt bestimmt werden. Sicherlich hängt sie von der Plasmadichte ab und diese wiederum ist in bestimmten Grenzen eine Funktion der Mikrowellenlei-stungsdichte im Entladungsgebiet. Sie ist vermutlich einige Größenordnungen höher als bei metallischen Oberflächen (∼ 50 µm) und nicht konstant über die Länge der Vorrichtung.

Weiterhin hat sich gezeigt, daß die bekannte Vorrichtung kaum in der Lage ist, eine Plasmaentladung bei niedrigeren Drücken als 8x10⁻² mbar aufrechtzuerhalten. Zur Erhöhung der Flexibilität der Vorrichtung wäre es wünschenswert, Betriebsbedingungen für eine Plasmaentladung ohne Magnetfeldunterstützung auch bei niedrigeren Drücken zu gewährleisten.

Eine Vorrichtung zur Erzeugung von Plasma ist in JP01184921 beschrieben, wobei durch ein Wandteil einer Vakuumkammer eine koaxiale Mikrowellenstruktur eingesetzt ist. Eine weitere Vorrichtung zur Erzeugung von Plasma mit Hilfe von elektromagnetischen Wechselfeldern mit einem stabförmigen Zentralleiter und einem rohrförmigen Leiter ist in US 4566403 beschrieben, wobei die isolierung einfach das Vorderteil des Leiters abschirmt.

Der vorliegenden Erfindung liegt die Aufgabe zugrunde, die Nachteile der bekannten Vorrichtung zu verbessern und darüber hinaus so auszubilden, daß sie für die Beschichtung von größeren, planen und dreidimensionalen Substraten geeignet ist und nur jeweils eine Öffnung in der Wand der Vakuumkammer benötigt wird.

Diese Aufgabe wird erfindungsgemäß dadurch gelöst, daß sich in den vom stabförmigen Leiter und dem Isolierrohr gebildeten Ringraum ein rohrförmiger Leiter koaxial zum stabförmigen Leiter erstreckt, wobei der zwischen dem stabförmigen Leiter und dem rohrförmigen Leiter gebildete, radial innere Ringspalt mit dem Hohlleiter der Quelle korrespondiert und der vom Isolierrohr und dem rohrförmigen Leiter gebildete radial äußere Ringspalt mit dem Hohlleiter einer zweiten Quelle in Verbindung steht.

Weitere Ausführungsmöglichkeiten, Einzelheiten und Merkmale sind in den Patentansprüchen näher beschrieben und gekennzeichnet.

Die Erfindung läßt die verschiedensten Ausführungsmöglichkeiten zu; eine davon ist in der anhängenden Zeichnung rein schematisch und im Längsschnitt näher dargestellt.

Die Vorrichtung besteht im wesentlichen aus dem durch das Wandteil 1 der Vakuumkammer 13 hindurchgeführten Isolierrohr 2 (einem Glasrohr) mit einem zu diesem koaxial angeordneten stabförmigen Leiter 3, dessen eines Ende mit dem Rechteckhohlleiter 10 der Quelle 9 fest verbunden ist, einem rohrförmigen Leiter 4, der sich koaxial zum stabförmigen Leiter 3 im vom Isolierrohr 2 und dem stabförmigen Leiter 3 gebildeten Ringspalt hineinerstreckt, einem Abstandsring 5, der dafür sorge trägt, daß der Ringspalt 14 eingehalten wird und der beispielsweise aus einem Kunststoff gefertigt ist, einer Umlenkkappe 6, die die Ringspalte 14 und 15 miteinander verbindet, einer Metallhülse 7, die in das Isolierrohr 2 eingeschoben ist und einen Außenleiter bildet, einem zwischen dem Isolierrohr 2 und der Kammerwand 1 eingelegten Rundschnurring 12, dem mit der Metallhülse 7 fest verbundenen Rechteckhohlleiter 10' einer Quelle 8 und den in den Rechteckhohlleitern 10,10' verschiebbar angeordneten Abstimmgliedern 11,11'.

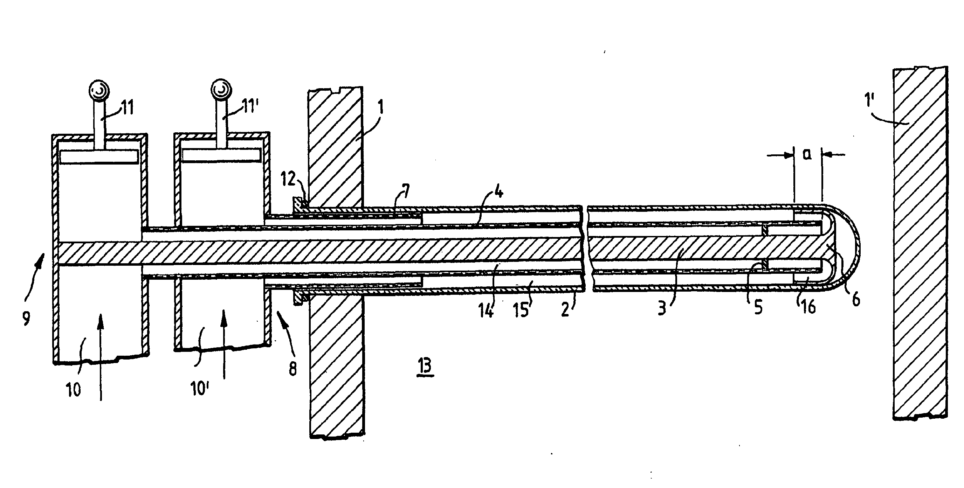

In der in der Zeichnung dargestellten Vorrichtung wird ein Teil der Mikrowellengesamtleistung, nahezu die Hälfte, auf herkömmliche Art dem Plasma koaxial zugeführt (über den Rechteckhohlleiter 10' unter Zuhilfenahme von Abstimmgliedern 11' von links her durch die Koaxialleitung, bestehend aus 4 und 7), der Rest der Mikrowellengesamtleistung, nahezu die Hälfte, wird über den Rechteckhohlleiter 10 mit Abstimmglied 11, eine koaxiale Umwegleitung, bestehend aus dem Innenleiter 3 und dem Außenleiter 4, einer abschließenden koaxialen Umlenkvorrichtung (Klappe 6) für Leitungswellen und einer kurzen koaxialen Leitung mit dem Innenleiter 4 und dem Außenleiter 7 von der gegenüberliegenden Seite her zugeführt.

Die Zuführung von Mikrowellenleistung an die Vorrichtung muß nicht zwangsläufig über Rechteckhohlleiter erfolgen, sondern kann auch über andere geeignete Wellenleitungsvorrichtungen erfolgen. Auch müssen die der Vorrichtung über zwei Wellenleitungsvorrichtungen zugeführten Mikrowellen nicht zwangsweise phasenkorreliert sein.

Die gesamte Vorrichtung kann in ihrer Länge an die jeweilige Applikation angepaßt werden, insbesondere bei sehr langen Ausführungen muß aus Stabilitätsgründen eine Scheibe 5 aus dielektrischem Material mit geringer Mikrowellenabsorption vorgesehen werden, um die koaxialen Leiter 3,4 und 7 in konzentrischer Form zu halten.

Die gesamte Vorrichtung befindet sich innerhalb eines Behältnisses aus einem vakuumdichten, hitzebeständigen, aber mikrowellendurchlässigen Material (z. B. wasserarmes Quarzglas, Aluminiumoxidkeramik, Zirkonoxidkeramik), wobei in der Vorrichtung Atmosphärendruck herrscht und außerhalb des Isolierrohres 2 ein Gasdruck, der für die Zündung und Unterhaltung einer Plasmaentladung geeignet ist. Das Isolierrohr 2 ist nur an einer Stelle durch die Wand 1 eines Vakuumbehältnisses (z. B. Plasmaprozeßreaktor) 13 geführt und mit diesem vakuumdicht verbunden.

Die beschriebene Vorrichtung hat folgende Vorteile:
- Gleiche Leistungsfähigkeit wie eine zweiseitig gespeiste und befestigte Vorrichtung mit dem Vorteil einseitiger Speisung und Befestigung;
- Beibehaltung der sehr geringen Querschnittsfläche der gesamten Vorrichtung auch bei sehr langen Bauformen (z. B. 30 mm Durchmesser des dielektrischen Behältnisses bei einer Länge von 2000 mm);
- Ideal für die Verwendung/Nachrüstung in Bandbeschichtungsanlagen.

## Patentansprüche

1. Vorrichtung zur Erzeugung von Plasma in einer Vakuumkammer (13) mit Hilfe von elektromagnetischen Wechselfeldern, mit einem nur an einer Stelle durch ein Wandteil (1) einer Vakuumkammer hindurch führbaren, vakuumdichten Isolierrohr (2), einem darin koaxial angeordneten stabförmigen Leiter (3) sowie einem rohrförmigen Leiter (4), der koaxial zum stabförmigen Leiter (3) im vom vakuumdichten Isolierrohr (2) und dem stabförmigen Leiter(3) gebildeten Ringspalt angeordnet ist und diesen in einen radial äusseren Ringspalt (15) und einen radial inneren Ringspalt (14) unterteil und einem ersten und zweiten Hohlleiter (10,10') und einer ersten und zweiten Quelle (9,8); wobei der radial innere Ringspalt (14) mit dem ersten Hohlleiter (10) der ersten Quelle (9) für elektromagnetishe Wechselfelder korrespondiert und der radial äussere Ringspalt (15) mit dem zweiten Hohlleiter (10') der zweiten Quelle (8) für elektromagnetishe Wechselfelder in Verbindung steht, **dadurch gekennzeichnet, dass** eine Umlenkkappe (6) vorgesehen ist, die dem radial inneren Ringspalt (14) und den radial äusseren Ringspalt (15) miteinander verbindet.

2. Vorrichtung nach Anspruch 1, weiterhin **gekennzeichnet**, dass das Isolierrohr (2) an seinem den ersten und zweiten Quellen (8, 9) abgewandten Ende von der Umlenkkappe (6) verschlossen ist, deren radial äusserer, an der Wand des Isolierrohrs (2) anliegender Teil eine sich in Richtung auf die ersten und zweiten Quellen (8, 9) erstreckende Manschette (16) aufweist, die sich, einen Aussenleiter um ein Mass (a) in den radial äusseren Ringspalt (15) hinein erstreckt, wobei die zentrale Partie der Umlenkkappe (6) fest mit dem stabförmigen Leiter (3) verbunden ist oder mit diesem einstückig ausgebildet ist.

3. Vorrichtung nach Anspruch 1, weiterhin **gekennzeichnet**, daß die äußere Form der Umlenkkappe (6) etwa die Gestalt eines geraden Kreiszylinders hat, dessen Rotationsachse sich gleichsinnig mit der Längsachse des stabförmigen Leiters (3) erstreckt, wobei die den ersten und zweiten Quellen (8,9) zugewandte Stirnfläche der Umlenkkappe (6) eine kreisringförmige Rinne mit einer halbkreisflächigen Querschnittsfläche aufweist, wobei die radial innere, von der Rinne umschlossene Partie der Stirnfläche mit dem stabförmigen Leiter (3) verbunden ist und die etwa zylindrische Mantelfläche der Umlenkkappe (6) dicht an der Innenwand des Isolierrohrs (2) anliegt.

4. Vorrichtung nach Anspruch 2, weiterhin **gekennzeichnet, daß** die Umlenkkappe (6) eine kuppelförmige Konfiguration mit einem kugelsegmentförmigen Teil und einem sich an dieses anschlieβenden kreisringzylindrischen Teil aufweist, wobei in die Grundfläche des Kugelsegments eine konzentrische, torusförmige Nut eingeschnitten ist, deren Gürtelkreis an die zylindrische Innenfläche des kreisringzylindrischen Teils angrenzt und deren Kehlkreis am freien Ende des stabförmiges Leiters (3) anliegt oder mit diesem einstückig ausgebildet ist, wobei sich die Längsachse des stabförmiges Leiters (3) gleichsinnig mit der Rotationsachse der Umlenkkappe (6) erstreckt.

## Claims

1. Device for plasma generation in a vacuum chamber (13) using electromagnetic alternating fields, with a vacuum-tight insulating pipe (2) which can be guided through a wall part (1) of a vacuum chamber at one place only, a rod-like conductor (3) arranged coaxially therein and a tubular conductor (4) which is arranged coaxial to the rod-like conductor (3) in the ring gap formed by the vacuum-tight insulating pipe (2) and the rod-like conductor (3) and divides this gap into a radial outer ring gap (15) and a radial inner ring gap (14), and with a first and second hollow conductor (10, 10') and a first and second source (9, 8); wherein the radial inner ring gap (14) corresponds with the first hollow conductor (10) of the first source (9) for electromagnetic alternating fields and the radial outer ring gap (15) is connected with the second hollow conductor (10') of the second source (8) for electromagnetic alternating fields, **characterised in that** a deflector cap (6) is provided which connects the radial inner ring gap (14) and the radial outer ring gap (15) together.

2. Device according to claim 1, furthermore **characterised in that** the insulating pipe (2) at its end facing away from the first and second sources (8, 9) is closed by the deflector cap (6) whose radial outer part lying at the wall of the insulating pipe (2) has a sleeve (16) extending in the direction of the first and a second sources (8, 9), which sleeve, forming an outer conductor, extends by dimension (a) into the radial outer ring gap (15), wherein the central part of the deflector cap (6) is firmly connected with the rod-like conductor (3) or is formed as one piece with this.

3. Device according to claim 1, furthermore **characterised in that** the outer form of the deflector cap (6) has approximately the shape of a straight circular cylinder, the rotation axis of which extends in the same direction as the longitudinal axis of the rod-like conductor (3), wherein the face of the deflector cap (6) facing the first and second sources (8, 9) has a circular channel with a semi-circular cross-section surface, wherein the radial inner part of the face surrounding the channel is connected with the rod-like conductor (3) and the approximately cylindrical casing surface of the deflector cap (6) lies tightly on the inner wall of the insulating pipe (2).

4. Device according to claim 2, furthermore **characterised in that** the deflector cap (6) has a dome-like configuration with a sphere-segment-shaped part and a circular ring cylindrical part connecting to this, wherein in the base surface of the sphere segment is cut a concentric, toroid groove, the great circle of which borders the cylindrical inner face of the circular ring cylindrical part and the gorge circle of which lies against the free end of the rod-like conductor (3) or is formed as one piece with this, wherein the longitudinal axis of the rod-like conductor (3) extends in the same direction as the rotation axis of the deflector cap (6).

## Revendications

1. Dispositif de génération de plasma dans une, chambre à vide (13) à l'aide de champs électromagnétiques alternatifs, ledit dispositif comprenant un tube isolant (2) étanche au vide et pouvant traverser en un seul endroit une partie de paroi (1) d'une chambre à vide, un conducteur (3) en forme de barre placé coaxialement à l'intérieur dudit tube isolant ainsi qu'un conducteur tubulaire (4) qui est disposé coaxialement au conducteur (3) en forme de barre dans l'espace annulaire formé par le tube isolant(2), étanche au vide, et le conducteur (3) en forme de barre et qui subdivise cet espace annulaire en un espacé annulaire radialement extérieur (15) et en un espace annulaire radialement intérieur (14), et des premier et second conducteur creux (10, 10') et des première et seconde sources (9, 8); le premier espace annulaire radialement intérieur (14) correspondant au premier conducteur creux (10) de la source (9) de champs électromagnétiques alternatifs et le premier espace annulaire radialement extérieur (15) étant en liaison avec le deuxième conducteur creux (10') de la deuxième source (8) de champs électromagnétiques alternatifs, **caractérisé en ce qu'**il est prévu une coiffe déflectrice (6) qui relie entre eux l'espace annulaire radialement intérieur (14) et l'espace annulaire radialement extérieur (15).

2. Dispositif selon la revendication 1, **caractérisé en outre en ce que** le tube isolant (2) est fermé à son extrémité, opposée aux première et seconde sources (8, 9), par la coiffe déflectrice (6) dont la partie radialement extérieure, portant sur la paroi du tube isolant (2), comporte un manchon (16) qui s'étend en direction des première et seconde sources (8, 9) et qui s'étend, en formant un conducteur extérieur, sur une distance (a) en direction de l'espace annulaire radialement extérieur (15), la partie centrale de la coiffe déflectrice (6) étant reliée rigidement au conducteur (3) en forme de barre ou étant conformée d'une seule pièce avec celui-ci.

3. Dispositif selon la revendication 1, **caractérisé en outre en ce que** la forme extérieure de la coiffe déflectrice (6) est a peu près celle d'un cylindre droit à base circulaire dont l'axe de révolution s'étend dans le même sens que l'axe longitudinal du conducteur (3) en forme de barre, la surface frontale, de la coiffe déflectrice (6), dirigée vers les première et seconde sources (8, 9), possède une rainure en forme d'anneau circulaire et de section semi-circulaire, la partie radialement intérieure, entourée par la rainure, de là surface frontale étant reliée au conducteur (3) en forme de barre et la surface d'enveloppe à peu près cylindrique de la coiffe déflectrice (16) portant de façon étanche contre la paroi intérieure du tube isolant (2).

4. Dispositif selon la revendication 2, **caractérisé en outre en ce que** la coiffe déflectrice (6) a une configuration en dôme dotée d'une partie en forme de segment de sphère et d'une partie cylindrique en forme d'anneau circulaire se raccordant à la partie précédente, une gorge torique concentrique étant ménagée dans la surface de base du segment de sphère, gorge dont le cercle équatorial borde la surface intérieure cylindrique de la partie cylindrique en forme d'anneau circulaire et dont le cercle de striction porte contre l'extrémité libre du conducteur (3) en forme de barre ou est conformé d'une seule pièce avec celui-ci, l'axe longitudinal du conducteur (3) en forme de barre s'étendant dans le même sens que l'axe de rotation de la coiffe déflectrice (6).
